# EUROPEAN PATENT SPECIFICATION

(11) **EP 0 525 962 B1**
(45) Date of publication and mention of the grant of the patent: **19.05.1999**
(21) Application number: 92305483.7
(22) Date of filing: 15.06.1992
(51) Int. Cl.: H04B 7/005, H03G 3/20, H04B 7/26

(54) **Cellular telephone with transmitter power level control**
Zellulartelefon mit Sendeleistungssteuerung
Téléphone cellulaire avec commande de puissance de l'émetteur

(30) Priority: 02.08.1991 GB 9116724
(43) Date of publication of application: 03.02.1993
(73) Proprietor: NOKIA MOBILE PHONES (U.K.) LIMITED, Camberley, Surrey GU15 3SP (GB)
(72) Inventor: Menadue, Andrew, Gwinear, Cornwall TR27 5HB (GB); Ashworth, Ian, Basingstoke, Hants RG24 0LQ (GB)
(74) Representative: Frain, Timothy John

(56) References cited:
- EP-A- 0 369 135
- EP-A- 0 392 079
- EP-A- 0 416 613
- FR-A- 2 614 158
- GB-A- 2 213 002
- GB-A- 2 229 609
- GB-A- 2 233 517

## Description

This invention relates to a cellular radio telephone, particularly but not exclusively a hand-held portable cellular telephone.

By way of background explanation, the cellular radio telephone system divides a geographical area into a plurality of adjoining cells each including a stationary transmitting and receiving base station connected to the conventional fixed-wire telephone network. Each cell is designed to allow a cellular telephone within the cell to access the fixed-wire network, and vice versa. Hence, the particular cell which receives the transmitting and/or receiving signal of a cellular telephone is the cell which is made operative for transmitting and/or receiving the call. So, for example, when a cellular telephone user attempts to make a call, the cell whose base station receives the strongest signal will be the one which effects the connection for that call. If the cellular telephone then moves beyond the effective range of the cell originally handling the call, another cell which receives the signal more strongly will become operative by an automatic transfer or 'hand-over' system. Hand-over may occur many times during a call depending on the distance traveled by the telephone and the number of effective cells through which the telephone passes.

Within each cell the respective base station monitors the strength of the signals received from the various terminals communicating therewith and may from time to time issue a request over the air for an individual terminal to increase or decrease its transmitting power, for example as the distance between the terminal and the base station varies. The terminal responds by adjusting the gain of the transmitter amplifying means under microprocessor control. Generally the amplifying means is operable at one of a plurality of predetermined output power levels which are selected automatically in response to the request from the base station for a change in the level of the output power. The power levels are defined in the system specification. For each power level a nominal value is specified together with a permitted tolerance range.

Cellular radio telephones fall into two main categories, namely mobiles and hand portables, although there is also an intermediate category known as transportables. As the name implies, a hand portable telephone is relatively lightweight and small in size and operates from an internal, rechargeable battery pack so that it may readily be carried around by the user. A mobile telephone, on the other hand, is permanently installed in a vehicle and operates from the vehicle's own (higher voltage) power supply. A mobile has the advantage over a hand portable that it can transmit at a higher power level, but a hand portable has the advantage that the user does not need to be in or near a vehicle to use the telephone, since it can be used anywhere within range of a base station. Unlike a mobile telephone, however, a hand portable does have the drawback of having a limited stand-by and call time before the internal battery pack needs to be recharged.

European Patent Application No. 0,248,033 (= PCT publication No. WO 87/02843) and corresponding US Patent No. 4,636,741 disclose a portable radio transceiver operable at a first set of power levels. The portable transceiver may be inserted into a vehicular adaptor for operation from the vehicle battery. When the portable transceiver is connected to the vehicle's (higher) voltage supply it becomes operable at a second set of power levels which include at least one level which is higher than any of the power levels in the first set of power levels. The portable transceiver is thus capable of higher power operation when connected to the vehicle's (higher) voltage supply.

In the context of portable cellular telephones the term "stand-by time" means the life of the internal battery pack in "stand-by mode", i.e. when the telephone is not being used either for making or receiving a call, and "talk time" is the battery life in "call mode", i.e. when the telephone is being used for making and/or receiving a call. In current portable cellular telephones the talk time is typically in the range of 1-2 hours and the stand-by time is in the range of 6-18 hours. In recent years advances have been made in extending the battery life. However there is still a need to find new ways of extending the operational endurance of the battery still further.

By way of example British patent application GB-A-2,230,405 discloses an electrical power supply for a hand portable cellular telephone having receiver and transmitter stages operable at different voltage levels. The power supply is in the form of a battery pack comprising a stack of series connected rechargeable cells. In call mode both the receiver and transmitter are powered by the full cell stack developing maximum voltage. In stand-by mode the transmitter is disabled and the receiver is powered by half the cells providing only half the full voltage. Switching means are actuated to connect alternately the first half of the cell stack and then the second half of the cell stack on a periodic basis. Power consumption is thus reduced, e.g. by 10-15 mA in stand-by mode thus increasing battery life.

European Patent Application No. 0,392,079 and corresponding US Patent No. 5,086,508 disclose a radio transceiver including a control section for setting a transmitting output level higher or lower than a prescribed output level within a tolerance range, in response to a signal from a level conversion circuit selectable with two switches or automatically.

According to a first aspect of the present invention there is provided a cellular radio telephone comprising a transceiver including amplifying means operable at one of a plurality of predetermined output power levels selected automatically in response to a signal indicative of a requirement for a change in level of the output power, and a voltage source providing a supply voltage for the amplifying means, characterized by means enabling the user to select the output power of the amplifying means from two different values for the highest of the power levels while maintaining the same voltage source for the amplifying means, the output power of the amplifying means for each of the lower power levels having a single value.

A radio telephone in accordance with the invention has the advantage that for the highest power level, the user can manually select the output power from two different values, without changing the voltage supply applied to the amplifying means. Specifically, the higher value may correspond substantially with the nominal value (defined in the system specification) for the power level in question, while the lower value is chosen to fall within the margin of tolerance (permitted by the system specification) for that power level. Thus, as far as the system is concerned, the two selectable output power values are essentially indistinguishable and are regarded as the same power level. However, particularly at the higher power levels, the tolerances are relatively wide so that there can be an appreciable difference between the two selectable output power values. Consequently, transmission at the lower output power value can represent a significant power saving compared with the nominal power level.

In essence a cellular telephone in accordance with the invention has the capability of transmitting not only at the standard nominal power levels defined in the system specification, but also at one or more subsidiary levels. The user has the option of selecting whether the transmitter will operate at the higher standard power level(s) or the lower subsidiary power level(s). Transmission at the lower power level(s) can be regarded as a battery save mode since overall power consumption is reduced and consequently battery life is extended. The user may choose to suspend the battery save mode, for example in areas of poor reception.

In a particular embodiment the telephone may include means for monitoring a parameter associated with a signal received from a base station. The control signal generating means may be adapted to suspend the battery save mode automatically when the monitored parameter of the received signal falls below a threshold value. In this way the output power is automatically restored to the higher value when the received signal quality deteriorates even though the user has selected the battery save mode. The quality of the signal received at the terminal (telephone) is assumed to correspond with the quality of the signal received by the base station. If the quality of the signal received by terminal deteriorates it is likely that the quality of the signal received by the base station has similarly deteriorated and below a threshold value it is therefore preferable for the maximum output power level of the terminal to be restored.

In a preferred embodiment the output power selecting means comprise means, such as one of the keys present externally on the telephone, for selecting one of a set of pre-set operating instructions stored in memory and indicated, e.g. in menu format, on visual display means. In this manner the user can readily select and de-select the battery save feature using the telephone keys which are ordinarily associated with other functions. The selection and de-selection of this feature may be accompanied by an appropriate message such as "BATTERY SAVE ON" and "BATTERY SAVE OFF" on the visual display.

An embodiment of the invention will now be described, by way of example, with reference to the accompanying drawings, in which:-
Figure 1 is a perspective view of a portable cellular telephone in accordance with the invention,
Figure 2 is a schematic diagram of the keypad, microprocessor, and major functional elements of the telephone in Figure 1, and
Figure 3 is a schematic diagram of the transmitter power amplifier stage of the telephone in Figure 1.

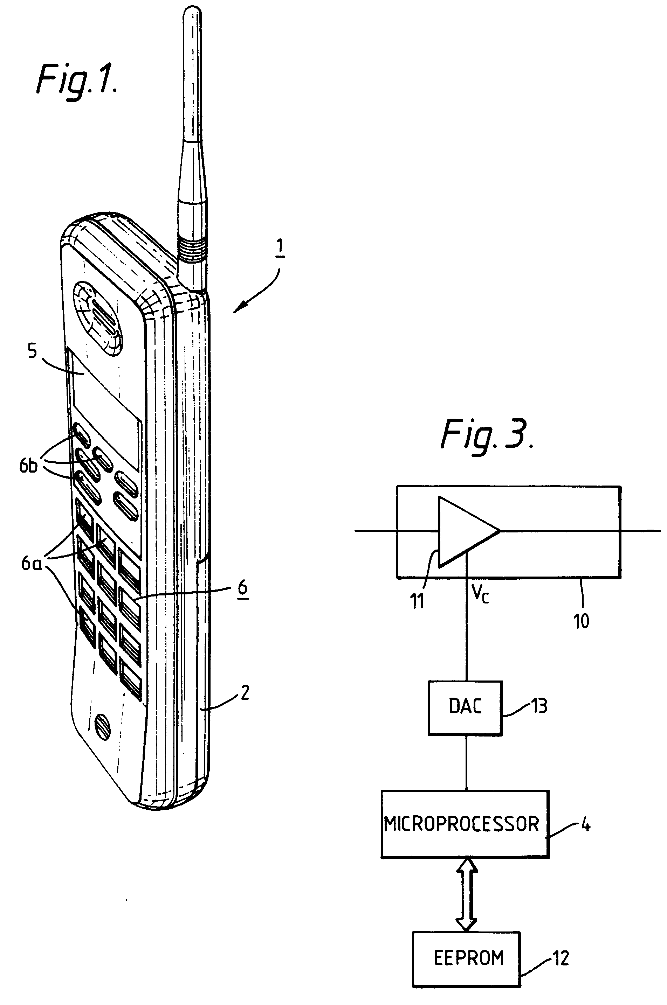

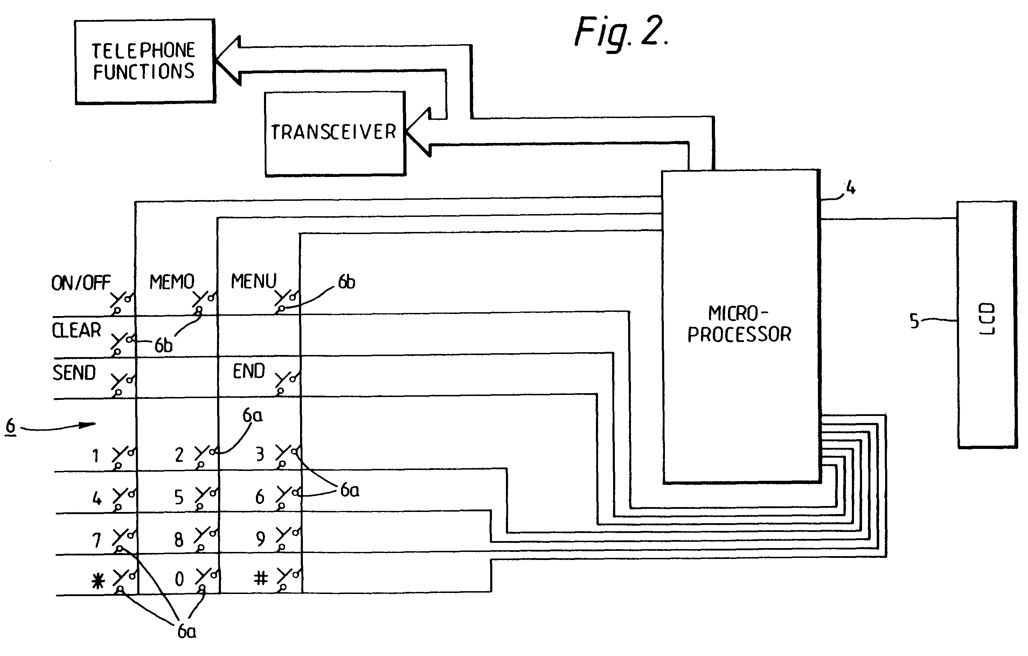

The portable radio telephone shown in Figure 1 is a cellular telephone 1 powered by a removable rechargeable battery pack 2. The telephone 1 includes a transceiver and all the other features conventionally found in a cellular telephone, as shown schematically in Figure 2. A microprocessor 4 is employed to control all the basic functions of the telephone and to control the keypad and display functions. Alternatively, however, the telephone functions may be controlled by a master microcomputer, while the keypad and display functions are under the control of a separate slave microcomputer coupled to communicate with the master microcomputer.

The user-interface of telephone 1 comprises a display, e.g. a liquid crystal display 5, itself well-known in the art and a keypad 6 on the front of the telephone 1. The display is coupled to and regulated by the microprocessor 4 in the usual manner. The keypad 6 essentially comprises two main sets of keys, namely alpha-numeric keys 6a associated with alpha-numeric data especially for dialing telephone numbers, but also (optionally) for entering alphanumeric data into the telephone memories, e.g. a subscriber number index; and a set of function keys 6b for enabling various predetermined functions or operations.

The keys 6a are arranged in four rows of three keys each. As is conventional for the numeric key layout of a telephone, the top row comprises keys for numbers 1, 2 and 3 respectively, the second row down for numbers 4, 5 and 6 respectively, the next row down for numbers 7, 8 and 9 respectively, and the bottom row for ∗, 0 and # respectively. Some or all of these keys may also be associated with alphabet information, as again is quite conventional. The alphabetic rather than numeric data is selected for example by preceding the alphanumeric keystroke with another predetermined keystroke or set of keystrokes, specifically using the function keys.

As is usual in cellular telephones, the keys 6b include a "SEND" and "END" key for respectively initiating and terminating a telephone call. Another key, specifically located in the top left-hand corner is an "ON/OFF" key for turning the telephone on and off. Another of the function keys may be a menu or function key labeled, for example, "MENU" or "FUNCTION" or with a suitable abbreviation thereof. Depression of this key enables a variety of pre-set menus, the related instructions of which are stored in memory, to be viewed on display 5 and selectively enabled. The various menus are selected by depressing the appropriate alphanumeric keys after depressing the "MENU" or "FUNCTION" key. The relevant menu is shown to the user in words or abbreviations on the display panel 5. For example, the user may be able to select the ringing tone by appropriate menu selection. More sophisticated options may also be available via the menu facility. For example, the user may be able to enable the so-called Discontinuous Transmission mode which employs a voice activated switch which helps to reduce battery drain by transmitting only when speech is input to the microphone.

In accordance with the present invention a special menu facility is provided to permit manual selection of a battery save mode. Any predetermined sequence of keystrokes may be employed to select the respective menu which may display a legend such as "BATTERY SAVE ON" and "BATTERY SAVE OFF" on the display panel 5. In a particular embodiment the following sequence of keystrokes were used to call up the battery save mode menu. Firstly the MENU key is depressed three times in succession in order to enter the third layer of menu functions, other menu functions being accessible via other menu layers. These other menus may be accessed by pressing the MENU key once for the first layer of menu functions, and twice for the second layer of menu functions. Next the user keys in a four digit personal identification number (PIN) followed by the digit "0". A message (e.g. BATTERY SAVE ON or BATTERY SAVE OFF) will now be shown on the display 5 indicating whether or not the battery save mode is currently enabled. The alternative battery mode may be enabled simply by depressing another predetermined key of the alphanumeric key set 6a, specifically, for example the MENU key. The battery save mode can be toggled off and on by repeatedly depressing the MENU key. Suitably the menu mode may be exited by pressing the "END" key of function key set 6b.

The transmitter power control itself will now be described with reference to Figure 3 which shows the transmitter power amplifier stage of the portable cellular telephone in Figures 1 and 2. The transmitter power amplifier stage comprises a power module 10 including a voltage controlled variable gain amplifier 11. The power module used by the Applicant was a Motorola SHWE1084 available from Motorola Inc, Schaumburg, Illinois, USA. The power output of module 10 is determined by the control voltage V_{c} applied to the amplifier 11. The output of the power module may be maintained at a uniform level by the use of a conventional level control circuit (not shown) in the form of a negative feedback loop. The control voltage V_{c} to be applied to the amplifier 11 is determined by microprocessor 4 in response to a request received from a base station to increase or decrease the output power of the transmitter. A set of values indicative respectively of the set of control voltages to be applied to the amplifier 11 are stored in EEPROM memory 12. The values stored in the memory 12 are used by the microprocessor 4 to apply an appropriate signal to a digital-to-analogue converter (DAC) 13 which in turn applies the appropriate control voltage V_{c} to the amplifier 11 in accordance with the following table (Table 1), which shows the standard power levels for a class 4 portable unit in the TACS and AMPS systems:

**TABLE 1**

| Standard Power Level | Subsidiary Power Level | V_{c}/V | dBm | Output Power/mw |
|---|---|---|---|---|
| 0(1,2) | | 2.73 | 28 | 600 |
| | 0+ | 2.35 | 26 | 400 |
| 3 | | 1.97 | 24 | 251 |
| 4 | - | 1.52 | 20 | 100 |
| 5 | - | 1.22 | 16 | 40 |
| 6 | - | 1.04 | 12 | 16 |
| 7 | - | 0.90 | 8 | 6 |

Hence when the transmitter is operating at power level 4, for example, the control voltage V_{c} applied to amplifier 11 is 1.52V and the output power is 100mW. If the base station requests an increase in power output the microprocessor responds by reading the adjacent appropriate power level value stored in EEPROM 12 and applying an appropriate signal to DAC 13. Accordingly the DAC 13 applies a control voltage of 1.97 volts to the amplifier 11 and the output power is increased to 251 mW. The transmitter is now operating at power level 3. If a request for a further power increase is made the transmitter would ordinarily step up to power level 0. (It is noted that in a class 4 portable unit levels 0, 1 and 2 are not differentiated). At this level the control voltage V_{c} applied by DAC 13 is increased to 2.73V and the output power is accordingly increased to 600mW.

It can be seen from the table that the standard power levels specified in the TACS and AMPS systems are spaced apart by 4dB. Each level has a tolerance margin of +2dB/-4dB. Thus an actual power output falling within +2dB/-4dB of the nominal value will be regarded by the system as within tolerance and therefore transmitting at the requested level. The present invention exploits this by setting a subsidiary power level 0+ between the standard power level 0 and standard power level 3, as shown in the table. In an embodiment implemented by the Applicant the power level 0+ was chosen to be 2dB below standard power level 0. The corresponding control voltage applied to amplifier 11 is 2.35 and the output power value is 400mW. Clearly the power saving between standard power level 0 and the subsidiary power level 0+ is 200mW which will save appreciable battery current and hence extend the call time with a given battery. The microprocessor 4 will always select from EEPROM 12 the appropriate value to enable the subsidiary power level 0+ in preference to the standard power level 0 when the user has selected the battery save option in accordance with the procedure described above. On the other hand the microprocessor 4 will select from EEPROM 12 the appropriate value to enable the standard power level 0 when the user has turned the battery save feature off in accordance with the procedure described above. Thus it will be seen that when the transmitter is operating at power level 3 and the base station requests an increase in output power from the telephone, the next power level which is enabled will depend on whether or not the battery save mode has been selected by the user.

In a modified embodiment the quality of the signal received by the portable telephone may be monitored and if the quality falls below a predetermined threshold while the transmitter is operating at the subsidiary power level 0+ the battery save mode is automatically disabled. The control voltage V_{c} applied to the amplifier 11 is therefore changed to 2.73V and the output power is consequently increased to the maximum level of 600mW. In one arrangement the standard power level 0 will then remain permanently enabled (i.e. the battery save mode will remain disabled) until such time as the battery save mode is manually re-enabled by the user. Alternatively, assuming the battery save mode has been manually selected, the telephone will automatically revert back to transmitting at the subsidiary power level 0+ when the received signal quality exceeds the threshold level. In other words, once the battery save mode has been manually selected, the output power at the maximum level may be switched automatically between the standard power level 0 and the subsidiary power level 0+ depending on the quality of the received signal. Suitably it may be the strength of the received signal which is monitored. The quality of the signal received by the telephone is assumed to correspond with the quality of the signal transmitted from the telephone and received by the base station. If the quality of the signal received by the telephone deteriorates it is likely that the quality of the signal transmitted by the telephone has similarly deteriorated when it is received by the base station.

In principle subsidiary power levels may also be provided at one or more of the lower power levels such that when the battery save mode is selected the respective subsidiary power level will be enabled in preference to the standard power level resulting in generally reduced power consumption and, therefore, extended battery life. However, it can be seen from the table that the power saving at lower levels is less significant because, in absolute values, the power levels become progressively closer together towards the lower levels. Moreover, there is a risk that if the power output at a lower level is reduced the base station will request the telephone to step up to the next power level and consequently the advantages of the subsidiary power level will be lost. At the maximum power level 0, the transmitter cannot by definition step up to a higher level and therefore maximum advantage is likely to be achieved by implementing the subsidiary power level in associated with the maximum power level.

In view of the foregoing description it will be evident to a person skilled in the art that various modifications may be made within the scope of the present invention as defined in the claims.

## Claims

1. A cellular radio telephone (1) comprising
a transceiver including amplifying means (11) operable at one of a plurality of predetermined output power levels selected automatically in response to a signal indicative of a requirement for a change in level of the output power, and
a voltage source providing a supply voltage for the amplifying means (11), characterized by
means (6,4) enabling the user to select the output power of the amplifying means (11) from two different values for the highest of the power levels while maintaining the same voltage source for the amplifying means (11), the output power of the amplifying means (11) for each of the lower power levels having a single value.

2. A cellular radio telephone (1) as claimed in claim 1, including
means (13) for applying a control signal to the amplifying means (11) whereby the output power is varied in accordance with the control signal applied thereto, and
means (4,12) for generating a respective first control signal for each of the plurality of power levels, and a second control signal for the highest of said power levels,
wherein the output power selecting means (6,4) determines for said highest power level whether the first control signal or the second control signal is applied to the amplifying means (11).

3. A cellular radio telephone (1) as claimed in claim 2, wherein the control signal generating means (4,12) includes memory means (12) for storing values indicative of the control signals to be applied to said amplifying means (11), said memory means (12) being adapted to store a respective first value associated with each of said first control signals and a second value associated with said second control signal.

4. A cellular radio telephone (1) as claimed in claim 2 or claim 3, wherein a first one of the two selectable output power values substantially corresponds with the nominal value of the highest power level and the other selectable output power value is lower than said first value.

5. A cellular radio telephone (1) as claimed in claim 4, wherein the first one of the two selectable output power values substantially corresponds with the nominal value of the highest power level according to the system specification, and the other selectable output power value falls within the margin of tolerance permitted by the system specification for the highest power level.

6. A cellular radio telephone (1) as claimed in claim 4, or claim 5, including means for monitoring a parameter associated with a signal received from a base station, wherein the control signal generating means are adapted to revert automatically from generating the second control signal to generating the first control signal when the monitored parameter of the received signal falls below a threshold level.

7. A cellular radio telephone (1) as claimed in any of the preceding claims, wherein the output power selecting means (6,4) comprise at least one manually operable key (6a,6b) present externally on the telephone.

8. A cellular radio telephone (1) as claimed in claim 7, wherein the at least one key (6a,6b) is adapted to be associated with at least one alternative function apart from output power selection.

9. A cellular radio telephone (1) as claimed in any of the preceding claims wherein the output power selecting means (6,4) comprise means for selecting an appropriate one of a set of pre-set operating instructions stored in memory and indicated on visual display means (5).

10. A cellular radio telephone (1) as claimed in claim 9, wherein the operating instructions are indicated on the visual display means (5) in the form of a menu.

## Patentansprüche

1. Zellulares Funktelefon (1), enthaltend:
einen Sendeempfänger mit Verstärkermitteln (11), die bei einem von einer Mehrzahl von vorbestimmten Ausgangslelstungspegeln betreibbar sind, der automatisch in Antwort auf ein Signal ausgewählt wird, das für einen Bedarf einer Änderung des Pegels der Ausgangsleistung kennzeichnend ist, und
eine Spannungsquelle, die für die Verstärkermittel (11) eine Versorgungsspannung zur Verfügung stellt, **gekennzeichnet durch**
Mittel (6,4), die es dem Benutzer ermöglichen für den größten der Leistungspegel die Ausgangsleistung der Verstärkermittel (1 1) aus zwei verschiedenen Werten auszuwählen, während für die Verstärkermittel (11) die gleiche Spannungsquelle beibehalten wird, wobei für jeden der niedrigeren Leistungspegel die Ausgangsleistung der Verstärkermittel (11) auf einen Wert setzbar ist.

2. Zellulares Funktelefon (1) nach Anspruch 1, mit:
Mitteln (13) zum Anlegen eines Steuersignals an die Verstärkermittel (11), wobei die Ausgangsleistung gemäß dem angelegten Steuersignal verändert wird, und
Mitteln (4,12) zur Erzeugung eines jeweiligen ersten Steuersignals für jeden der Mehrzahl von Leistungspegeln, und eines zweiten Steuersignals für den größten der Leistungspegel, wobei die Ausgangsleistungs-Auswahlmittel (6,4) bestimmen, ob für den größten Leistungspegel das erste Steuersignal oder das zweite Steuersignal an die Verstärkermittel (11) angelegt wird.

3. Zellulares Funktelefon (1) nach Anspruch 2, bei dem die Steuersignal-Erzeugungsmittel (4,12) Speichermittel (12) zur Speicherung von Werten enthalten, die für die an die Verstärkermittel (11) anzulegenden Steuersignale kennzeichnend sind, wobei die Speichermittel (12) geeignet sind einen jeweiligen mit jedem der ersten Steuersignale assoziierten ersten Wert und einen mit dem zweiten Steuersignal assoziierten zweiten Wert zu speichern.

4. Zellulares Funktelefon (1) nach Anspruch 2 oder 3, bei dem ein erster der zwei wählbaren Ausgangsleistungwerte im wesentlichen mit dem Sollwert des größten Leistungspegels korrespondiert, und der andere wählbare Ausgangsleistungswert kleiner als der erste Wert ist.

5. Zellulares Funktelefon (1) nach Anspruch 4, bei dem der erste der zwei wählbaren Ausgangsleistungwerte im wesentlichen mit dem Sollwert des größten Leistungspegels gemäß der Systemspezifikation korrespondiert, und der andere wählbare Ausgangsleistungspegel innerhalb des Toleranzbereichs liegt, der von der Systemspezifikation für den größten Leistungspegel zugelassen ist.

6. Zellulares Funktelefon (1) nach Anspruch 4 oder 5, mit Mitteln zur Überwachung eines Parameters, der mit einem von einer Basisstation erhaltenen Signal assoziiert ist, wobei die Steuersignal-Erzeugungsmittel ausgelegt sind, um automatisch von der Erzeugung des zweiten Steuersignals in die Erzeugung des ersten Steuersignals zurückzufallen, wenn der überwachte Parameter des empfangenen Signals unter einen Schwellenwert fällt.

7. Zellulares Funktelefon (1) nach irgendeinem der vorangegangenen Ansprüche, bei dem die Ausgangsleistungs-Auswahlmittel (6,4) mindestens eine extern am Telefon ausgebildete manuell betätigbare Taste (6a,6b) aufweisen.

8. Zellulares Funktelefon (1) nach Anspruch 7, bei dem die mindestens eine Taste (6a, 6b) ausgelegt ist, um abgesehen von der Auswahl der Ausgangsleistung mit mindestens einer alternativen Funktion assoziiert zu sein.

9. Zellulares Funktelefon (1) nach irgendeinem der vorangegangenen Ansprüche, bei dem die Ausgangsleistungs-Auswahlmittel (6, 4) Mittel zur Auswahl einer entsprechenden Betriebsanweisung aus aus einem Satz von vorgesetzten Betriebsanweisungen enthalten, die im Speicher gespeichert sind und auf visuellen Anzeigemitteln (5) angezeigt werden.

10. Zellulares Funktelefon (1) nach Anspruch 9, bei dem die Betriebsanweisungen auf den visuellen Anzeigemitteln (5) in Menüform angezeigt werden.

## Revendications

1. Radiotéléphone cellulaire (1) comprenant :
un émetteur-récepteur comportant un moyen d'amplification (11) pouvant fonctionner à l'un d'une pluralité de niveaux prédéterminés de la puissance de sortie choisis automatiquement en réponse à un signal représentatif d'une demande de changement du niveau de la puissance de sortie, et
une source de tension fournissant une tension d'alimentation pour le moyen d'amplification (11), caractérisé par :
un moyen (6, 4) permettant à l'utilisateur de sélectionner la puissance de sortie du moyen d'amplification (11) parmi deux valeurs différentes pour le plus élevé des niveaux de la puissance tout en maintenant la même source de tension pour le moyen d'amplification (11), la puissance de sortie du moyen d'amplification (11) pour chacun des niveaux plus bas de la puissance ayant une seule valeur.

2. Radiotéléphone cellulaire (1) selon la revendication 1, comportant :
un moyen (13) pour appliquer un signal de commande au moyen d'amplification (11), d'où il résulte que la puissance de sortie est modifiée en conformité avec le signal de commande qui lui est appliqué, et
un moyen (4, 12) pour générer un premier signal de commande respectif pour chacun de la pluralité des niveaux de la puissance, et un second signal de commande pour le plus élevé desdits niveaux de la puissance,
dans lequel le moyen de sélection de la puissance de sortie (6, 4) détermine ledit niveau le plus élevé de la puissance si le premier signal de commande ou le second signal de commande est appliqué au moyen d'amplification (11).

3. Radiotéléphone cellulaire (1) selon la revendication 2, dans lequel le moyen générateur de signal de commande (4, 12) comprend un moyen de mémoire (12) pour stocker des valeurs représentatives des signaux de commande devant être appliqués audit moyen d'amplification (11), ledit moyen de mémoire (12) étant destiné à stocker une première valeur respective associée à chacun desdits premiers signaux de commande et une seconde valeur associée audit second signal de commande.

4. Radiotéléphone cellulaire (1) selon la revendication 2 ou la revendication 3, dans lequel une première valeur parmi les deux valeurs de la puissance de sortie pouvant être sélectionnées correspond sensiblement à la valeur nominale du niveau le plus élevé de la tension et l'autre valeur de la puissance de sortie pouvant être sélectionnée est inférieure à ladite première valeur.

5. Radiotéléphone cellulaire (1) selon la revendication 4, dans lequel la première valeur des deux valeurs de la puissance de sortie pouvant être sélectionnées correspond sensiblement à la valeur nominale du niveau le plus élevé de la puissance en conformité avec la spécification du système, et l'autre valeur de la puissance de sortie pouvant être sélectionnée tombe dans la marge de tolérance permise par la spécification du système pour le niveau le plus élevé de la puissance.

6. Radiotéléphone cellulaire (1) selon la revendication 4 ou la revendication 5, comprenant un moyen pour surveiller un paramètre associé à un signal reçu qui provient d'une station de base, dans lequel le moyen générateur de signal de commande est destiné à revenir automatiquement de la production du second signal de commande à la production du premier signal de commande lorsque le paramètre surveillé du signal reçu tombe au-dessous d'un niveau de seuil.

7. Radiotéléphone cellulaire (1) selon l'une quelconque des revendications précédentes, dans lequel le moyen de sélection de la puissance de sortie (6, 4) comprend au moins une touche pouvant être actionnée manuellement (6a, 6b) présente à l'extérieur du téléphone.

8. Radiotéléphone cellulaire (1) selon la revendication 7, dans lequel cette touche (6a, 6b) est destinée à être associée avec au moins une fonction alternative en dehors de la sélection de la puissance de sortie.

9. Radiotéléphone cellulaire (1) selon l'une quelconque des revendications précédentes, dans lequel le moyen de sélection de la puissance de sortie (6, 4) comprend un moyen pour choisir une instruction appropriée d'un jeu d'instructions de fonctionnement pré-établi qui sont stockées en mémoire et indiquées sur un moyen d'affichage visuel (5).

10. Radiotéléphone cellulaire (1) selon la revendication 9, dans lequel les instructions de fonctionnement sont indiquées sur le moyen d'affichage visuel (5) sous la forme d'un menu.
